# DEMANDE DE BREVET EUROPEEN

(11) **EP 4 391 014 A1**
(43) Date de publication de la demande: **26.06.2024**
(21) Numéro de dépôt: 23214730.6
(22) Date de dépôt: 06.12.2023
(51) Int. Cl.: H01J 49/10, G01N 1/02, H01L 21/66, H01L 21/683, H01L 21/673

(54) **PROCÉDÉ DE DÉTERMINATION DU NIVEAU DE CONTAMINATION MÉTALLIQUE D'UN CONTAINER POUR PLAQUES DESTINÉES À LA MICROÉLECTRONIQUE**

(30) Priorité: 21.12.2022 FR 2214114
(71) Demandeur: Commissariat à l'énergie atomique et aux énergies alternatives, 75015 Paris (FR)
(72) Inventeur: BOUTRY, Delphine, 38054 GRENOBLE CEDEX 09 (FR); LARDIN, Thierry, 38054 GRENOBLE CEDEX 09 (FR)
(74) Mandataire: Brevalex

(57) **Abrégé**

L'invention a trait à un procédé d'estimation du niveau de contamination métallique d'un container pour plaques destinées à la microélectronique, ledit container comprenant une pluralité de fentes, chaque fente constituant un support pour accueillir une plaque, ledit procédé comprenant les étapes suivantes :
a) une étape d'introduction d'une plaque vierge dans une fente dudit container ;
b) une étape de retrait de la plaque de ladite fente ;
c) éventuellement, une étape de réitération des étapes a) et b) avec la même plaque dans tout ou partie des autres fentes du container ou de réitération des étapes a) et b) avec une autre plaque vierge différente pour chacune de tout ou partie des autres fentes du container ;
d) une étape d'analyse de la ou les plaque(s) au niveau d'au moins une de ses ou leurs zones, qui a ou ont été en contact direct avec la ou les fentes du container, au moyen d'une méthode de mesure de la contamination métallique.

## Description

### DOMAINE TECHNIQUE

L'invention se rapporte à un procédé de détermination du niveau de contamination métallique d'un container pour plaques destinées à la microélectronique et son application pour tester l'efficacité d'un protocole de décontamination métallique pour de tels containers.

L'invention se situe donc dans le domaine général de l'industrie microélectronique et, plus spécifiquement, de la fabrication des composants électroniques.

La fabrication des composants électroniques nécessite de très nombreuses étapes pour passer d'une plaque vierge, par exemple, une plaque de silicium, à une plaque comprenant des composants électroniques et des interconnexions entre eux.

Pour limiter les phénomènes de contamination susceptibles de dégrader les composants électroniques en cours d'élaboration, la fabrication desdits composants doit être réalisée dans un environnement d'un niveau de propreté connu et maîtrisé nécessitant la délimitation d'un espace et la maîtrise du nombre et de la qualité des contaminants, quelles que soient les variations de l'environnement extérieur et de l'activité réalisée à l'intérieur de l'espace susmentionné.

Pour ce faire, la fabrication des composants électroniques se déroule, classiquement, dans une salle blanche, c'est-à-dire une zone dont la propreté (par exemple, les poussières, les particules) et l'environnement (par exemple, l'humidité, la température) sont maîtrisés, le niveau de propreté étant notamment assuré par un système de filtration d'air. Par ailleurs, à chaque fin d'étape du procédé de fabrication, les plaques obtenues sont généralement isolées de l'atmosphère de la salle blanche en les plaçant dans des containers ayant chacun leur propre environnement dont la propreté est supérieure à celui de la salle blanche. Outre un rôle de stockage, ces containers permettent le transport des plaques d'un point à l'autre de la salle blanche pour que les plaques puissent ensuite être soumises à une autre étape du processus de fabrication ou être transportées d'une usine de fabrication à une autre.

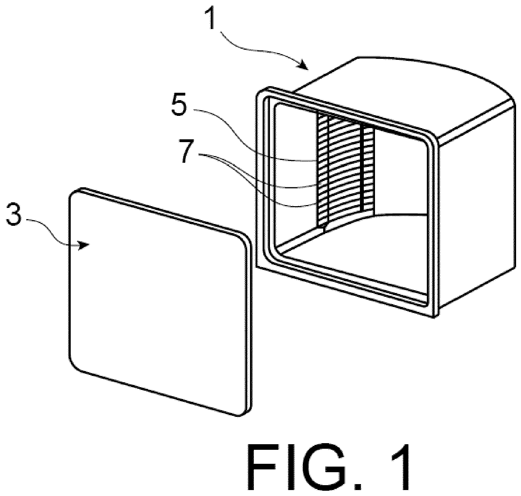

Pour des plaques de 300 mm de diamètre, les containers utilisés sont classiquement des containers dits « FOUPs » (FOUP correspondant à l'abréviation de la terminologie anglo-saxonne « *Front Opening Unified Pod* »), qui sont des containers en matière plastique permettant d'isoler les plaques de la contamination particulaire de la salle blanche et de manipuler les plaques de manière automatique. Ces containers, comme illustré sur la figure 1 jointe en annexe, comprennent les parties suivantes :
- une enveloppe comportant une coque 1 et une porte 3 ;
- à l'intérieur de la coque, un panier ou un insert 5 comprenant une pluralité de fentes 7 parallèles les unes aux autres, chaque fente étant destinée à former un support pour une plaque *via* des languettes de support délimitant l'espace de la fente.

Classiquement, un container dit FOUP présente une capacité de stockage de 25 plaques présentant un diamètre de 300 mm.

Tout au long du processus de fabrication des composants électroniques, les plaques sont soumises à des traitements distincts avec des éléments métalliques qui peuvent être distincts également, lesdites plaques étant stockées dans un container, tel que celui décrit ci-dessus, à l'issue de chaque traitement. Aussi, à chaque stockage, des éléments métalliques présents à la surface des plaques peuvent se déposer dans les fentes des containers au niveau des zones de contact entre lesdites plaques et lesdites fentes. Ces zones de contact constituent ainsi des zones privilégiées pour une contamination métallique croisée découlant du passage des éléments métalliques présents à la surface des plaques vers les zones de la fente, qui sont en contact direct avec les plaques. A terme d'un processus de fabrication, les containers peuvent ainsi se retrouver contaminés par tout ou partie des éléments du tableau périodique, tels que Li, AI, Fe, Ni, Cr, Ti, Ga, Mo, Ta, Nb, In, As provenant des plaques stockées et issues de différents dépôts successifs sur celles-ci. Ces containers peuvent être nettoyés mais le nettoyage actuel n'est pas entièrement satisfaisant, car il laisse de la contamination dans les fentes.

Actuellement, il est couramment procédé, de manière maîtrisée, à l'analyse de la contamination métallique des plaques et ce par des techniques telles que la spectrométrie de fluorescence des rayons X en réflexion totale (connue sous l'abréviation TXRF pour la terminologie anglaise «*Total reflection X-ray fluorescence spectrometry*»)*,* la VPD-DC ICPMS (abréviation correspondant à la terminologie anglaise « *Vapor phase decomposition-Droplet Collection Inductively Coupled Plasma Mass Spectrometry* »), la LPD ICPMS (abréviation correspondant à la terminologie anglaise « *Liquid phase decomposition-Inductively Coupled Plasma Mass Spectrometry* »).

Au vu de ce qui existe déjà, les auteurs de la présente invention se sont fixé pour objectif de proposer, de manière alternative, un procédé de détermination du niveau de contamination métallique d'un container pour plaques destinées à l'industrie microélectronique.

### EXPOSÉ DE L'INVENTION

L'invention a ainsi trait à un procédé d'estimation du niveau de contamination métallique d'un container pour plaques destinées à la microélectronique, ledit container comprenant une pluralité de fentes, chaque fente constituant un support pour accueillir une plaque, ledit procédé comprenant les étapes suivantes :
a) une étape d'introduction d'une plaque vierge dans une fente dudit container ;
b) une étape de retrait de la plaque de ladite fente ;
c) éventuellement, une étape de réitération des étapes a) et b) avec la même plaque dans tout ou partie des autres fentes du container ou de réitération des étapes a) et b) avec une autre plaque vierge différente pour chacune de tout ou partie des autres fentes du container ;
d) une étape d'analyse de la ou les plaque(s) au niveau d'au moins une de ses ou leurs zones, qui a ou ont été en contact direct avec la ou les fentes du container, au moyen d'une méthode de mesure de la contamination métallique.

Le procédé de l'invention consiste ainsi en une détermination indirecte du niveau de contamination métallique d'un container pour plaques, en ce sens que la ou les plaques vierges va (vont) entraîner avec elle(s) les éventuels éléments métalliques contaminants présents dans le container, la présence de ces éléments métalliques étant ensuite estimée par la mise en oeuvre de l'étape d) mentionnée ci-dessus.

Les containers pour plaques entrant dans le cadre de l'invention peuvent être des containers du type FOUP (FOUP correspondant à l'abréviation de la terminologie anglaise «*Front Opening Unified Pod* »), dont un exemple est représenté sur la figure 1 décrite ci-dessus. Ces containers sont classiquement destinés à accueillir des plaques circulaires (ou wafers) présentant un diamètre de 300 mm. Ces containers comprennent une pluralité de fentes destinées à accueillir les plaques circulaires, cette pluralité de fentes pouvant être pourvue au niveau d'un panier incorporé dans le container. Plus spécifiquement, ces containers peuvent comporter 25 fentes pouvant ainsi accueillir 25 plaques circulaires. Lorsque ce type de containers accueillent plusieurs plaques en même temps, celles-ci sont disposées de manière horizontale et sont parallèles les unes aux autres.

Les containers pour plaques entrant dans le cadre de l'invention peuvent être également destinés à accueillir des plaques circulaires (ou wafers) présentant un diamètre de 200 mm, ces dernières étant disposées de manière verticale dans lesdits containers.

Le procédé de l'invention comprend, en premier lieu, une étape d'introduction d'une plaque vierge dans une fente dudit container.

Par plaque vierge, il s'entend une plaque servant de composant de base pour la fabrication des composants électronique mais n'ayant encore subi aucune des étapes destinées à la fabrication de ces composants. Cette plaque vierge peut être une plaque en un matériau semi-conducteur et, de préférence, du silicium. Plus spécifiquement, cette plaque vierge peut être un wafer en silicium.

L'étape d'introduction de la plaque vierge peut être effectuée au moyen d'une pipette à vide, le contact entre la pipette à vide et la plaque vierge étant, de préférence, réalisé au niveau d'une zone, qui n'est pas une zone destinée à être en contact direct avec le container après introduction de la plaque dans une fente du container et ce afin d'éviter d'apporter une contamination au niveau des zones qui vont être analysées ultérieurement lors de l'étape d). Cette zone de contact entre la pipette à vide et la plaque vierge peut être la face arrière à l'exclusion des bords qui vont être en contact avec la fente du container.

La plaque est ensuite retirée de la fente, par exemple, au moyen d'une pipette à vide, le contact entre la pipette à vide et la plaque vierge se faisant également *via* une zone, qui n'a pas été en contact direct avec le container.

Les étapes a) et b) peuvent avantageusement être ensuite réitérées, avec la même plaque surtout ou partie des autres fentes restantes. Ainsi, en multipliant la mise en oeuvre des étapes a) et b) dans tout ou partie des autres fentes restantes, la plaque à l'issue de l'étape c) permet d'accéder, après analyse, à une estimation du niveau général de contamination métallique du container ou, plus spécifiquement, du panier incorporé dans le container.

En variante, les étapes a) et b peuvent être réitérées avec une autre plaque vierge différente pour chacune de tout ou partie des autres fentes du container, ce qui signifie, autrement dit, qu'il y aura, dans le cadre du procédé, autant de plaques vierges différentes utilisées que de fentes soumises aux étapes a) et b).

Avant introduction dans le container, la ou les plaque(s) vierge(s) peu(ven)t être soumise(s) à une étape de nettoyage, par exemple, chimique, et ce afin d'avoir un niveau de contamination métallique initiale le plus faible possible.

À titre d'exemple, lorsque le container est un container du type FOUP comprenant 25 fentes distinctes et qu'une seule plaque vierge est utilisée avec réitération des étapes a) et b), la première séquence d'étapes a) et b) peut être réalisée sur la première fente (en partant du bas du container) suivie, avec la plaque issue de la première séquence, d'une deuxième séquence d'étapes a) et b) réalisée sur la cinquième fente (en partant du bas du container) suivie, avec la plaque issue de la deuxième séquence, d'une troisième séquence d'étapes a) et b) réalisée sur la dixième fente (en partant du bas du container) suivie, avec la plaque issue de la troisième séquence, d'une quatrième séquence d'étapes a) et b) réalisée sur la quinzième fente (en partant du bas du container) suivie enfin, avec la plaque issue de la quatrième séquence, d'une cinquième séquence d'étapes a) et b) réalisée sur la vingt-cinquième fente (en partant du bas du container).

Selon le procédé de l'invention, il peut être intercalé, entre chaque étape a) et chaque étape b), une étape de déplacement du container selon un trajet prédéterminé, en particulier, un trajet qui correspond à celui qui serait réalisé entre une zone de mise en oeuvre d'une étape qui s'inscrit dans le processus de fabrication de composants électroniques et une zone de mise en oeuvre d'une étape ultérieure de ce processus (ce trajet correspondant ainsi à une simulation de trajet en salle blanche). Cette étape de déplacement peut être réalisée en plaçant le container sur un chariot et en déplaçant le chariot selon ce trajet prédéterminé pour simuler le transport des plaques dans un procédé de fabrication classique.

À l'issue des séquences d'étapes a) à b), lorsqu'il n'y pas réitération, ou à l'issue des séquences d'étapes a) à c), lorsqu'il y a réitération, la plaque ou les plaque(s) est (sont) soumise(s) à une étape d'analyse par une méthode de mesure de la contamination métallique au niveau d'au moins une de ses zones, qui ont été en contact direct avec les fentes du container. La ou lesdites zones peuvent correspondre aux bords de plaque(s) qui sont en contact direct avec les éléments délimitant les fentes ou encore peuvent correspondre au chanfrein (connu également sous l'appellation « *bevel* »).

La méthode de mesure de contamination métallique peut être, en particulier, la VPD-DC ICPMS (abréviation correspondant à la terminologie anglaise « *Vapor phase decomposition-Droplet Collection Inductively Coupled Plasma Mass Spectrometry* »).

À l'issue de l'étape d), nous disposons du niveau de contamination métallique de la ou des plaques utilisée(s) et il est possible ainsi d'en déduire indirectement une estimation du niveau de contamination métallique du container.

Ce procédé, comme son objet l'indique, permet d'estimer le niveau de contamination métallique d'un container ayant accueilli des plaques destinées à la fabrication de composants électroniques. Une fois ce niveau de contamination métallique estimée, le container peut être soumis à un protocole de décontamination métallique adapté au niveau de contamination métallique estimée, dès lors, bien entendu, que ce protocole de décontamination métallique est connu.

En revanche, si l'on souhaite déterminer de nouveaux protocoles de décontamination métallique efficaces pour un niveau de contamination métallique donnée, le procédé de l'invention peut également trouver application pour déterminer ces nouveaux protocoles.

Aussi, l'invention a également pour objet un procédé de test d'efficacité d'un protocole de décontamination métallique pour un container pour plaques destinées à la microélectronique, lequel container présentant un niveau de contamination métallique donné, ledit procédé comprenant les étapes suivantes :
i) une étape de soumission du container à un protocole de contamination métallique ;
ii) une étape de mise en oeuvre du procédé d'estimation du niveau de contamination métallique tel que défini ci-dessus avec le container issu de l'étape i) ;
iii) une étape de soumission du container issu de l'étape ii) au protocole de décontamination métallique, que l'on souhaite tester ;
iv) une étape de mise en oeuvre du procédé d'estimation du niveau de contamination métallique tel que défini ci-dessus avec le container issu de l'étape iii) ;
v) une étape de comparaison entre le niveau de contamination métallique estimé à l'issue de l'étape ii) et le niveau de contamination métallique estimé à l'issue de l'étape iv).

Par protocole de décontamination métallique, il s'entend un protocole pouvant impliquer des moyens physiques et/ou chimiques susceptibles de décontaminer le container en le ou lesdits éléments métalliques contaminants.

Ainsi, à l'issue de l'étape v), s'il ressort de l'étape de comparaison que le niveau de contamination métallique estimé est substantiellement inférieur à celui du container avant soumission au protocole de décontamination métallique, le protocole de décontamination métallique testé peut être considéré comme efficace pour le container.

Le protocole de décontamination métallique est mis en oeuvre avec un container présentant un niveau de contamination métallique donné, c'est-à-dire un container dont le niveau de contamination métallique est connu grâce à la mise en oeuvre des étapes i) et ii).

L'étape iv) de mise en oeuvre du procédé d'estimation sera, avantageusement, réalisée sur d'autres fentes que celles impliquées dans l'étape de mise en oeuvre du protocole d'estimation de l'étape ii).

Le protocole de contamination métallique de l'étape i) peut comprendre les opérations suivantes :
a) une opération d'introduction dans une fente du container d'une plaque dont la surface est revêtue d'un dépôt de composition connue ;
b) une opération de retrait de ladite plaque ;
c) les opérations d'introduction et de retrait étant réitérées une ou plusieurs fois avec la même plaque et au niveau de la même fente ;
d) une opération de maintien de la plaque au niveau de la fente ;
e) éventuellement, au moins une répétition des opérations a) à d) avec une autre plaque revêtue d'un autre dépôt de composition connue, ladite plaque étant différente pour chacune des répétitions, chacune des répétitions étant mise en oeuvre dans une autre fente que celle(s) utilisée(s) pour la mise en oeuvre des opérations a) à c) antérieures.

À la suite de l'opération d), lorsqu'il n'y a pas répétition ou à la suite de l'opération e), lorsqu'il y a répétition(s), le container comprenant la ou les plaques est, avantageusement, soumis à une opération de déplacement du container selon un trajet prédéterminé, en particulier, un trajet qui correspond à celui qui serait réalisé entre une zone de mise en oeuvre d'une étape qui s'inscrit dans le processus de fabrication de composants électroniques et une zone de mise en oeuvre d'une étape ultérieure de ce processus (ce trajet correspondant ainsi à une simulation de trajet en salle blanche). Cette opération de déplacement peut être réalisée en plaçant le container sur un chariot et en déplaçant le chariot selon ce trajet prédéterminé.

Pour chacune des plaques utilisées, le protocole de contamination métallique peut comprendre, en outre, à la suite de l'opération d), lorsqu'il n'y a pas répétition ou à la suite de l'opération e), une opération de répétition des opérations a) à d) dans une autre fente que celle initialement occupée par la plaque concernée et, de préférence, dans une fente qui n'a pas été préalablement occupée par une plaque, le container à l'issue de cette opération de répétition pour chacune des plaques étant de nouveau soumis à une opération de déplacement selon un trajet prédéterminé.

À l'issue du protocole de contamination métallique, la ou les plaques insérée(s) dans le container est(sont) retirée(s).

Le protocole ci-dessus est destiné à contaminer volontairement en élément(s) métallique(s) à une concentration élevée (induite par le passage répété des plaques dans une fente donnée) pour pouvoir tester ensuite un protocole de décontamination donné, cette concentration élevée pouvant être comprise dans une gamme allant de 10¹¹ at/cm² à 5*10¹³ at/cm² pour chacun des éléments contaminants métalliques.

À titre d'exemple, pour un container du type FOUP comprenant 25 fentes et pour cinq plaques revêtues chacune d'un dépôt de composition différente connue, le protocole de contamination métallique du container peut comprendre les opérations suivantes :
1°) une opération d'introduction dans la première fente du container (en partant du bas du container) d'une première plaque (par exemple, une plaque, dont la surface est revêtue d'un dépôt de Al₂O₃) suivie d'une opération de retrait, cette opération d'introduction et de retrait étant ensuite réitérée au moins trois fois, la plaque étant au final maintenue dans ladite fente ;
2°) une opération d'introduction dans la quatrième fente du container (en partant du bas du container) d'une deuxième plaque (par exemple, une plaque, dont la surface est revêtue d'un dépôt de NiO) suivie d'une opération de retrait, cette opération d'introduction et de retrait étant ensuite réitérée au moins trois fois, la plaque étant au final maintenue dans ladite fente ;
3°) une opération d'introduction dans la neuvième fente du container (en partant du bas du container) d'une troisième plaque (par exemple, une plaque, dont la surface est revêtue d'un dépôt de LiNbO₃) suivie d'une opération de retrait, cette opération d'introduction et de retrait étant ensuite réitérée au moins trois fois, la plaque étant au final maintenue dans ladite fente ;
4°) une opération d'introduction dans la quatorzième fente du container (en partant du bas du container) d'une quatrième plaque (par exemple, une plaque, dont la surface est revêtue d'un dépôt de GaN) suivie d'une opération de retrait, cette opération d'introduction et de retrait étant ensuite réitérée au moins trois fois, la plaque étant au final maintenue dans ladite fente ;
5°) une opération d'introduction dans la vingtième fente du container (en partant du bas du container) d'une cinquième plaque (par exemple, une plaque, dont la surface est revêtue d'un dépôt de MoS₂) suivie d'une opération de retrait, cette opération d'introduction et de retrait étant ensuite réitérée au moins trois fois, la plaque étant au final maintenue dans ladite fente ;
6°) une opération du déplacement du container comprenant les cinq plaques selon un trajet prédéterminé ;
7°) une opération de répétition des opérations 1°) à 5°) pour chacune des plaques mais dans une fente différente de la fente initialement utilisée et, de préférence, dans une fente, qui n'a pas été préalablement occupée par une plaque (par exemple, pour la première plaque, une répétition de l'opération 1°) dans la deuxième fente du container; pour la deuxième plaque, une répétition de l'opération 2°) dans la cinquième fente du container ; pour la troisième plaque, une répétition de l'opération 3°) dans la dixième fente du container; pour la quatrième plaque, une répétition de l'opération 4°) dans la quinzième fente du container et pour la cinquième plaque, une répétition de l'opération 5°) dans la vingt-et-unième fente du container;
8°) une opération de déplacement du container comprenant les cinq plaques selon un trajet prédéterminé ;
9°) une étape de retrait des cinq plaques du container.

Les opérations d'introduction et de retrait sont, avantageusement, réalisées au moyen d'une pipette à vide, le contact entre la pipette à vide et la plaque étant, de préférence, réalisé au niveau d'une zone, qui n'est pas une zone destinée à être en contact direct avec le container après introduction de la plaque dans une fente du container.

Que ce soit pour le procédé d'estimation du niveau de contamination métallique d'un container ou le procédé de test d'efficacité d'un protocole de décontamination métallique pour un container, ceux-ci sont, avantageusement, mis en oeuvre dans une salle blanche, à savoir, un espace dans lequel la concentration en particules dans l'air est contrôlée et correspondant, classiquement, à l'espace, dans lequel se déroule la fabrication des composants électroniques.

D'autres caractéristiques et avantages de l'invention apparaîtront mieux à la lecture du complément de description qui suit, qui se rapporte à un exemple conforme à l'invention.

Bien entendu, cet exemple n'est donné qu'à titre d'illustration de l'objet de l'invention et ne constitue en aucun cas une limitation de cet objet.

### BRÈVE DESCRIPTION DE LA FIGURE

La figure 1, déjà commentée, illustre un container du type FOUP.

### EXPOSÉ DÉTAILLÉ DE MODES DE RÉALISATION PARTICULIERS

### EXEMPLE :

Cet exemple illustre l'application du procédé d'estimation du niveau de contamination métallique d'un container pour tester différents protocoles de nettoyage pour des containers présentant un niveau de contamination métallique donné.

Dans un premier temps, un protocole a été mis au point pour contaminer volontairement un container à des concentrations élevées.

Pour ce faire, différents types de plaques de contamination ont été utilisés :
- un premier type de plaque de silicium présentant, en surface, un dépôt de Al₂O₃ (nommé, par la suite, plaque Si/Al₂O₃) ;
- un deuxième type de plaque de silicium présentant, en surface, un dépôt de NiO (nommé, par la suite, plaque Si/NiO) ;
- un troisième type de plaque de silicium présentant, en surface, un dépôt de LiNbO₃ (nommé, par la suite, plaque Si/LNO) ;
- un quatrième type de plaque de silicium présentant, en surface, un dépôt de GaN (nommé, par la suite, plaque Si/GaN) ; et
- un cinquième type de plaque de silicium présentant, en surface, un dépôt de MoS₂ (nommé, par la suite, plaque Si/MoS₂).

Ces différents types de plaques se présentent sous forme de disques de 200 mm de diamètre.

Le container utilisé, dans le cadre de cet exemple, est un container destiné à accueillir des plaques circulaires (ou wafers) présentant un diamètre de 200 mm, ledit container comprenant un panier muni de 25 fentes pour accueillir lesdites plaques. Le panier utilisé est un panier neuf, c'est-à-dire qu'il n'a jamais été utilisé au préalable.

Le protocole de contamination métallique volontaire est le suivant :
1°) Une plaque Si/Al₂O₃ est saisie par sa face arrière au moyen d'une pipette à vide et est placée dans la fente 1 (c'est-à-dire la première fente en partant du bas du container) en faisant 10 allers-retours dans cette fente. Ladite plaque est ensuite laissée dans cette fente ;
2°) Une plaque Si/NiO est saisie par sa face arrière au moyen d'une pipette à vide et est placée dans la fente 4 (c'est-à-dire la quatrième fente en partant du bas du container) en faisant 10 allers-retours dans cette fente. Ladite plaque est ensuite laissée dans cette fente ;
3°) Une plaque Si/LNO est saisie par sa face arrière au moyen d'une pipette à vide et est placée dans la fente 9 (c'est-à-dire la neuvième fente en partant du bas du container) en faisant 10 allers-retours dans cette fente. Ladite plaque est ensuite laissée dans cette fente ;
4°) Une plaque Si/GaN est saisie par sa face arrière au moyen d'une pipette à vide et est placée dans la fente 14 (c'est-à-dire la quatorzième fente en partant du bas du container) en faisant 10 allers-retours dans cette fente. Ladite plaque est ensuite laissée dans cette fente ; et
5°) Une plaque Si/MoS₂ est saisie par sa face arrière au moyen d'une pipette à vide et est placée dans la fente 20 (c'est-à-dire la vingtième fente en partant du bas du container) en faisant 10 allers-retours dans cette fente. Ladite plaque est ensuite laissée dans cette fente ;
6°) Le container ainsi chargé est soumis à une simulation de transport en le plaçant sur un chariot, lequel se déplace selon un trajet correspondant à un déplacement d'un équipement à un autre en salle blanche ;
7°) La plaque Si/Al₂O₃ est saisie par sa face arrière au moyen d'une pipette à vide et est placée dans la fente 2 (c'est-à-dire la deuxième fente en partant du bas du container) en faisant 10 allers-retours dans cette fente. Ladite plaque est ensuite laissée dans cette fente ;
8°) La plaque Si/NiO est saisie par sa face arrière au moyen d'une pipette à vide et est placée dans la fente 5 (c'est-à-dire la cinquième fente en partant du bas du container) en faisant 10 allers-retours dans cette fente. Ladite plaque est ensuite laissée dans cette fente ;
9°) La plaque Si/LNO est saisie par sa face arrière au moyen d'une pipette à vide et est placée dans la fente 10 (c'est-à-dire la dixième fente en partant du bas du container) en faisant 10 allers-retours dans cette fente. Ladite plaque est ensuite laissée dans cette fente ;
10°) La plaque Si/GaN est saisie par sa face arrière au moyen d'une pipette à vide et est placée dans la fente 15 (c'est-à-dire la quinzième fente en partant du bas du container) en faisant 10 allers-retours dans cette fente. Ladite plaque est ensuite laissée dans cette fente ; et
11°) La plaque Si/MoS₂ est saisie par sa face arrière au moyen d'une pipette à vide et est placée dans la fente 21 (c'est-à-dire la vingt-et-unième fente en partant du bas du container) en faisant 10 allers-retours dans cette fente. Ladite plaque est ensuite laissée dans cette fente ;
12°) Le container ainsi chargé est soumis à une simulation de transport en le plaçant sur un chariot, lequel se déplace selon un trajet correspondant à un déplacement d'un équipement à un autre en salle blanche.

Pour le container ainsi contaminé et après en avoir retiré toutes les plaques, il est estimé, selon un mode particulier du procédé de l'invention, le niveau de contamination métallique, ce mode particulier répondant au protocole suivant :
1°) Une plaque en silicium vierge est saisie par sa face arrière au moyen d'une pipette à vide et est placée dans la fente 1 (c'est-à-dire la première fente en partant du bas du container) ;
2°) Le container est placé sur un chariot et soumis à une simulation de transport en salle blanche ;
3°) La plaque en silicium est retirée de la fente 1 au moyen d'une pipette à vide puis placée dans la fente 4 (c'est-à-dire la quatrième fente en partant du bas du container) puis le container est placé sur un chariot et soumis à une simulation de transport en salle blanche ;
4°) La plaque en silicium est retirée de la fente 4 au moyen d'une pipette à vide puis placée dans la fente 9 (c'est-à-dire la neuvième fente en partant du bas du container) puis le container est placé sur un chariot et soumis à une simulation de transport en salle blanche ;
5°) La plaque en silicium est retirée de la fente 9 au moyen d'une pipette à vide puis placée dans la fente 14 (c'est-à-dire la quatorzième fente en partant du bas du container) puis le container est placé sur un chariot et soumis à une simulation de transport en salle blanche ;
6°) La plaque en silicium est retirée de la fente 14 au moyen d'une pipette à vide puis placée dans la fente 20 (c'est-à-dire la vingtième fente en partant du bas du container) puis le container est placé sur un chariot et soumis à une simulation de transport en salle blanche ;
7°) La plaque en silicium est retirée du container et les bords de la plaque ayant été en contact direct avec les fentes sont analysés par VPD-ICP-MS, les résultats étant comparés à ceux obtenus avec une plaque en silicium vierge et témoin (c'est-à-dire n'ayant pas subi les étapes 1°) à 6°) susmentionnées) pour accéder à une estimation du niveau de contamination métallique.

Les résultats d'estimation pour le container pour les éléments Al, Ga, Li, Mo, Ni sont regroupés dans le tableau 1 ci-dessous.

**Tableau 1**

| Élément | Concentration (en at/cm²) |
|---|---|
| Al | 1,58*10¹¹ |
| Ga | 7,13*10¹² |
| Li | 1,77*10¹¹ |
| Mo | 1,32*10¹¹ |
| Ni | 9,64*10¹⁰ |

Une fois les résultats d'estimation obtenus, le container est nettoyé avec une solution de nettoyage donnée.

Une fois nettoyé, le container est soumis au mode particulier du procédé d'estimation de l'invention tel que défini ci-dessus, de sorte à déterminer le niveau de contamination métallique pour chacun des éléments Al, Ga, Li, Mo, Ni et Nb, la plaque en silicium vierge étant dans ce cas, placée respectivement dans les fentes 2, 5, 10, 15 et 21.

Les résultats d'estimation pour le container pour les éléments Al, Ga, Li, Mo et Ni sont reportés dans le tableau 2 ci-dessous.

**Tableau 2**

| Elément | Concentration (en at/cm²) |
|---|---|
| Al | 1,46*10¹¹ |
| Ga | 2,53*10¹¹ |
| Li | 5,14*10¹⁰ |
| Mo | 4,64*10¹⁰ |
| Ni | 8,33*10¹⁰ |

Il ressort que la solution de nettoyage testée est efficace pour Ga, Li et Mo mais s'avère inefficace pour Al et Ni.

## Revendications

1. Procédé d'estimation du niveau de contamination métallique d'un container pour plaques destinées à la microélectronique, ledit container comprenant une pluralité de fentes, chaque fente constituant un support pour accueillir une plaque, ledit procédé comprenant les étapes suivantes :
a) une étape d'introduction d'une plaque vierge dans une fente dudit container ;
b) une étape de retrait de la plaque de ladite fente ;
c) éventuellement, une étape de réitération des étapes a) et b) avec la même plaque dans tout ou partie des autres fentes du container ou de réitération des étapes a) et b) avec une autre plaque vierge différente pour chacune de tout ou partie des autres fentes du container ;
d) une étape d'analyse de la ou les plaque(s) au niveau d'au moins une de ses ou leurs zones, qui a ou ont été en contact direct avec la ou les fentes du container, au moyen d'une méthode de mesure de la contamination métallique.

2. Procédé selon la revendication 1, dans lequel le container pour plaques est un container du type FOUP ou un container destiné à accueillir des plaques circulaires présentant un diamètre de 200 mm.

3. Procédé selon la revendication 1 ou la revendication 2, dans lequel la plaque vierge est une plaque en silicium.

4. Procédé selon l'une quelconque des revendications 1 à 3, comprenant, en outre, une étape de nettoyage de la ou les plaque(s) vierge(s) avant introduction dans le container.

5. Procédé selon l'une quelconque des revendications 1 à 4, dans lequel l'étape d'introduction a) est effectuée au moyen d'une pipette à vide.

6. Procédé selon la revendication 5, dans lequel la plaque vierge et la pipette à vide sont en contact d'une zone, qui n'est pas une zone destinée à être en contact direct avec le container après introduction de la plaque dans une fente du container.

7. Procédé selon l'une quelconque des revendications 1 à 6, dans lequel l'étape de retrait de la plaque est réalisée au moyen d'une pipette à vide.

8. Procédé selon l'une quelconque des revendications 1 à 7, dans lequel, entre chaque étape a) et chaque étape b), il est intercalé une étape de déplacement du container selon un trajet prédéterminé.

9. Procédé selon l'une quelconque des revendications 1 à 8, dans lequel, pour l'étape d), la méthode de mesure de contamination métallique est la VPD-DC ICPMS.

10. Procédé de test d'efficacité d'un protocole de décontamination métallique pour un container pour plaques destinées à la microélectronique, lequel container présentant un niveau de contamination métallique donné, ledit procédé comprenant les étapes suivantes :
i) une étape de soumission du container à un protocole de contamination métallique ;
ii) une étape de mise en oeuvre du procédé d'estimation du niveau de contamination métallique tel que défini selon l'une quelconque des revendications 1 à 9 avec le container issu de l'étape i) ;
iii) une étape de soumission du container issu de l'étape ii) au protocole de décontamination métallique, que l'on souhaite tester ;
iv) une étape de mise en oeuvre du procédé d'estimation du niveau de contamination métallique tel que défini selon l'une quelconque des revendications 1 à 9 avec le container issu de l'étape iii) ;
v) une étape de comparaison entre le niveau de contamination métallique estimé à l'issue de l'étape ii) et le niveau de contamination métallique estimé à l'issue de l'étape iv).

11. Procédé selon la revendication 10, dans lequel le protocole de contamination métallique de l'étape i) comprend les opérations suivantes :
a) une opération d'introduction dans une fente du container d'une plaque dont la surface est revêtue d'un dépôt de composition connue ;
b) une opération de retrait de ladite plaque ;
c) les opérations d'introduction et de retrait étant réitérées une ou plusieurs fois avec la même plaque et au niveau de la même fente ;
d) une opération de maintien de la plaque au niveau de la fente ;
e) éventuellement, au moins une répétition des opérations a) à d) avec une autre plaque revêtue d'un autre dépôt de composition connue, ladite plaque étant différente pour chacune des répétitions, chacune des répétitions étant mise en oeuvre dans une autre fente que celle(s) utilisée(s) pour la mise en oeuvre des opérations a) à c) antérieures.

12. Procédé selon la revendication 11, dans lequel, à la suite de l'opération d), lorsqu'il n'y a pas répétition ou à la suite de l'opération e), lorsqu'il y a répétition(s), le container comprenant la ou les plaques est soumis à une opération de déplacement du container selon un trajet prédéterminé.

13. Procédé selon la revendication 11 ou la revendication 12, comprenant, en outre, pour chacune des plaques utilisées, à la suite de l'opération d), lorsqu'il n'y a pas répétition ou à la suite de l'opération e), une opération de répétition des opérations a) à d) dans une autre fente que celle initialement occupée par la plaque concernée.
